Europäisches Patentamt

European Patent Office

Office européen des brevets

(11) Publication number: **0 455 338 A1**

# EUROPEAN PATENT APPLICATION

(21) Application number: 91302568.0

(22) Date of filing: 25.03.91

(51) Int. Cl.⁵: **H01L 21/82, H01L 27/108**

(30) Priority: 30.04.90 US 516288

(43) Date of publication of application:
06.11.91 Bulletin 91/45

(84) Designated Contracting States:
DE FR GB IT

(71) Applicant: SGS-THOMSON
MICROELECTRONICS, INC.
1310 Electronics Drive
Carrollton Texas 75006(US)

(72) Inventor: Chan, Tsiu Chiu
1633 Camero Drive
Carrollton, Texas 75006(US)

(74) Representative: Palmer, Roger et al
PAGE, WHITE & FARRER 54 Doughty Street
London WC1N 2LS(GB)

(54) Dram cell structure.

(57) The storage plate of a DRAM cell capacitor is formed from a thin polycrystalline silicon layer. Oxide and nitride layers are formed thereon, followed by masking and removal of the oxide and nitride layers in regions other than the capacitor locations. The entire surface of the device is then oxidized, forming a thin oxide layer over the nitride layer at the capacitor locations, and oxidizing the exposed polycrystalline silicon regions. This forms oxide isolation of the capacitor charge storage plates, and provides an oxide-nitride-oxide dielectric for the capacitor.

FIG. 4

The present invention relates generally to semiconductor integrated circuits, and more specifically to the formation of a **DRAM** cell.

Dynamic random access memory (DRAM) cells are formed with one transistor and one capacitor. The quality of the capacitor has an impact on device performance. Poor quality capacitors tend to hold less charge and to have a higher charge leakage rate. Both of these factors negatively impact the cell, and hence device, performance.

It would be desirable to provide a method, and a structure formed thereby, which gives improved DRAM cell performance.

It is therefore an object of the present invention to provide a DRAM cell structure, and method for making such structure, which result in a DRAM cell having improved device characteristics.

It is a further object of the present invention to provide such a structure and method which is compatible with current process technology.

Therefore, according to the present invention, the storage plate of a DRAM cell capacitor is formed from a thin polycrystalline silicon layer. Oxide and nitride layers are formed thereon, followed by masking and removal of the oxide and nitride layers in regions other than the capacitor locations. The entire surface of the device is then oxidized, forming a thin oxide layer over the nitride layer at the capacitor locations, and oxidizing the exposed polycrystalline silicon regions. This forms oxide isolation of the capacitor charge storage plates, and provides an oxide-nitride-oxide dielectric for the capacitor.

The novel features believed characteristic of the invention are set forth in the appended claims. The invention itself however, as well as a preferred mode of use, and further objects and advantages thereof, will best be understood by reference to the following detailed description of an illustrative embodiment when read in conjunction with the accompanying drawings, wherein:

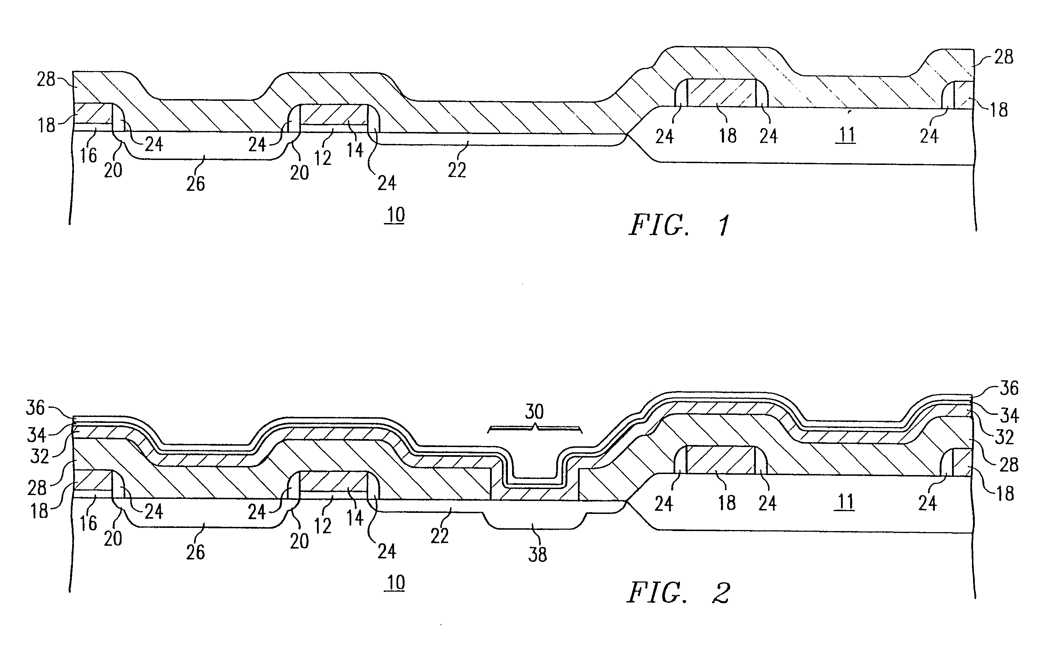

**Figures 1-4** illustrate a method for forming a DRAM cell according to the present invention.

The process steps and structures described below do not form a complete process flow for manufacturing integrated circuits. The present invention can be practiced in conjunction with integrated circuit fabrication techniques currently used in the art, and only so much of the commonly practiced process steps are included as are necessary for an understanding of the present invention. The figures representing cross-sections of portions of an integrated circuit during fabrication are not drawn to scale, but instead are drawn so as to illustrate the important features of the invention.

Referring to **Figure 1,** a substrate **10** is partially covered by a field oxide layer **11**. Gate oxide layer **12** and polycrystalline silicon gate **14** form the transfer gate for the capacitor which will be formed. Gate oxide layer **16** and polycrystalline silicon gates **18** are gates for other DRAM cells (not shown). Gates **14, 18** are generally referred to in the art as word lines.

Once the gates have been defined, an $N^-$ implant is made to define lightly doped drain (LDD) regions **20, 22**. Oxide sidewall spacers **24** are then formed by deposition of an oxide layer and etch back as known in the art. A photoresist mask is then used to perform an $N^+$ implant in the bit line contact drain regions **26**, while masking the contact region **22** for the capacitor. An undoped oxide layer **28** is then deposited over the surface of the device. Oxide layer **28** preferably has a depth of approximately 2000 angstroms, but may have a greater or lesser depth as required by the remainder of the process flow.

Referring to **Figure 2**, a mask is used to open a capacitor contact opening **30** in the oxide layer **28**. A polycrystalline silicon layer **32** is deposited over the surface of the device and doped N-type with a phosphorous implantation. Polycrystalline silicon layer **32** preferably has a thickness of approximately 500 angstroms.

An anneal step causes diffusion of dopant from the polycrystalline silicon layer **32** into the LDD region **22** beneath the contact opening **30**. This forms an $N^+$ contact region **38**.

A short etch is performed to clear any oxide on the polycrystalline silicon layer **32**, followed by growth of a thin thermal oxide layer **34**. The oxide layer **34** preferably has a thickness of approximately 20 angstroms. A thin nitride layer **36** is then deposited over the surface of the ship, preferably to a thickness of approximately 70 angstroms.

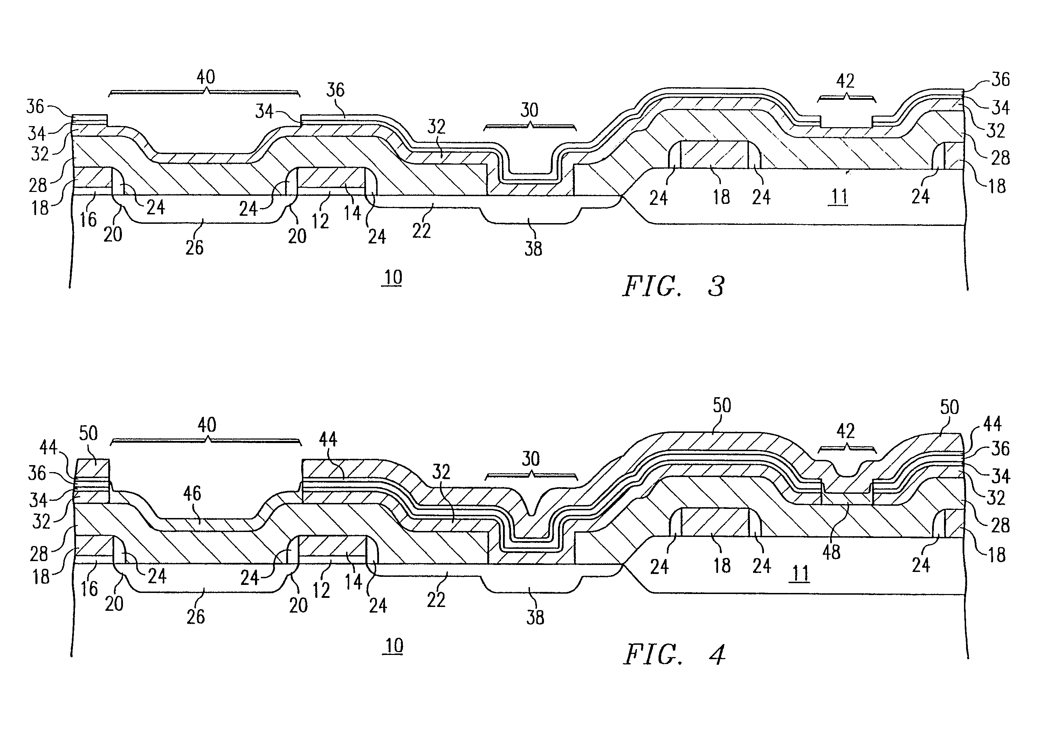

Referring to **Figure 3**, a mask is then used to define the charge storage plate of the capacitor. Nitride layer **36** and oxide layer **34** are etched away in regions **40, 42** to define a capacitor therebetween. Region **42** serves merely to separate two adjacent capacitors, while region **40** is larger and allows a bit line contact to be made to $N^+$ **26** at a later step in the process. Etching of the nitride **36** and oxide **34** layers within the openings **40, 42** causes some of polycrystalline silicon layer **32** to be etched away due to over etching. However, most of the polycrystalline silicon layer **32** within the openings **40, 42** will remain after the etch step.

Referring to **Figure 4**, the chip is thermally oxidized to convert the upper part of nitride layer **36** into a thin oxide layer **44**. This oxide layer **44** has a thickness of approximately 20 angstroms. Layers **34, 36,** and **44** form an ONO dielectric as known in the art. The exposed polycrystalline silicon within the openings **40, 42** is completely converted to oxide regions **46, 48** by this process. Oxide regions **46, 48** isolate the capacitor from its neighbors.

Polycrystalline silicon layer **50** is then deposited over the surface of the chip, and etched to define the top plate of the capacitor. Polycrystalline silicon layer **50** is etched only at the contact openings **40** where the bit lines will make contact with the $N^+$ region **26**. The top plate layer **50** is otherwise continuous, and shared by all capacitors. The device now has the structure shown in **Figure 4**, wherein an oxide-nitride-oxide dielectric separates the charge storage plate **32** and the ground plate **50** of the capacitor. Further process steps, including deposition of a dielectric, bit line formation, and passivation, are performed as in conventional processes.

DRAM cell capacitors formed as described above have a number of advantages over capacitors formed in traditional manners. Contact between the charge storage plate **32** of the capacitor and the active area **22** is made without requiring a prior annealing cycle. All of the transistors are protected by phosphorous doped poly (layer **32**) or phosphorous rich oxide **46, 48**, which serves to protect them from contamination during later processing steps.

Since the polycrystalline silicon layer **32** is not etched, but is instead converted to oxide, there is no "poly stick" problem. Poly sticks are formed when a polycrystalline silicon layer passes over a step, and is incompletely etched away during an anisotropic etch. Since the polycrystalline silicon layer **32** is not etched, there is no problem such as frequently occurs with over etching of such layer. In additional, since the polycrystalline silicon layer **32** is not etched away, the step height which normally occurs at the edges of the capacitor is reduced.

Since the oxide regions **46, 48** isolate the capacitor storage plates 32, it is not necessary to grow a sidewall oxide thereon. This reduces the amount of enclosure which must be included in the design rules around the capacitor plate. The nature of oxidizing the polycrystalline silicon provides a smooth transition at the edge of the capacitor plates **32**, reducing the physical stress on the edges of the capacitor. This tends to reduce the charge leakage at the edge of the capacitor, resulting in improved device characteristics.

While the invention has been particularly shown and described with reference to a preferred embodiment, it will be understood by those skilled in the art that various changes in form and detail may be made therein without departing from the spirit and scope of the invention.

## Claims

1. A method for forming a capacitor on an integrated circuit device, comprising the steps of:

forming a first polycrystalline silicon layer over the device;

forming a first oxide layer on the first polycrystalline silicon layer;

forming a nitride layer over the first oxide layer;

patterning the first oxide layer and the nitride layer to define capacitor regions, with remaining regions exposed;

oxidizing the exposed polycrystalline silicon regions, wherein a second oxide layer is also formed on the patterned nitride layer, and wherein the first oxide-nitride-second oxide layers together define a capacitor dielectric layer; and

forming a second polycrystalline silicon layer over the capacitor dielectric layer, wherein the first and second polycrystalline silicon layers define plates of the capacitor.

2. The method of Claim 1, further comprising the step of:

before forming the first polycrystalline silicon layer, forming an opening through an insulating layer to an underlying substrate, wherein the first polycrystalline silicon layer makes electrical contact with the substrate.

3. The method of Claim 1, further comprising the step of:

after forming the first polycrystalline silicon layer, implanting an impurity thereinto to dope it with a selected conductivity type.

4. The method of Claim 3, wherein the impurity comprises phosphorous.

5. A DRAM cell structure for an integrated circuit device, comprising:

a pass gate;

an insulating layer covering the pass gate and nearby portions of the device;

a doped first polycrystalline silicon layer covering said pass gate, wherein a first portion thereof defines a capacitor plate, and a second portion has been oxidized to provide an insulator;

a dielectric layer over the first polycrystalline silicon layer first portion; and

a second polycrystalline silicon layer over said dielectric layer, wherein said first and second polycrystalline silicon layers, with said dielectric layer, form a capacitor.

6. The cell structure of Claim 5, wherein said dielectric layer comprises a nitride layer sandwiched between two oxide layers.

EP 0 455 338 A1

FIG. 1

FIG. 2

FIG. 3

FIG. 4

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | PATENT ABSTRACTS OF JAPAN vol. 12, no. 254 (E-634)(3101), 16 July 1988; & JP - A - 6342164 (HITACHI) 23.02.1988 * abstract; figures * | 1-3 | H 01 L 21/82 H 01 L 27/108 |
| X | PATENT ABSTRACTS OF JAPAN vol. 13, no. 164 (E-745)(3512), 19 April 1989, & JP - A - 63316465 (HITACHI) 23.12.1988 * abstract; figure * | 5,6 | |
| A | PATENT ABSTRACTS OF JAPAN vol. 13, no. 166 (E-746), 20 April 1989; & JP - A - 64000756 (HITACHI) 05.01.1989 * abstract, figure * | 1,6 | |
| A | EP-A-0 282 629 (SIEMENS) * abstract; figure 5 * | 1,4,6 | |

TECHNICAL FIELDS SEARCHED (Int. Cl.5)

H 01 L

The present search report has been drawn up for all claims

| Place of search | Date of completion of search | Examiner |
|---|---|---|
| Berlin | 25 July 91 | JUHL A. |